# EUROPEAN PATENT APPLICATION

(11) **EP 4 047 108 A1**
(43) Date of publication of application: **24.08.2022**
(21) Application number: 20876019.9
(22) Date of filing: 09.10.2020
(51) Int. Cl.: C23C 14/54, C23C 14/24

(54) **FILM-FORMING METHOD AND FILM-FORMING APPARATUS**

(30) Priority: 15.10.2019 WO PCT/JP2019/040456
(71) Applicant: TOKAI UNIVERSITY EDUCATIONAL SYSTEM, Tokyo 151-0063 (JP); Shincron Co., Ltd., Kanagawa 220-8680 (JP)
(72) Inventor: MUROTANI, Hiroshi, Hiratsuka-shi, Kanagawa 259-1292 (JP); MIYAUCHI, Mitsuhiro, Yokohama-shi, Kanagawa 220-8680 (JP); OHTAKI, Yoshiyuki, Yokohama-shi, Kanagawa 220-8680 (JP); HASEGAWA, Tomokazu, Yokohama-shi, Kanagawa 220-8680 (JP); MATSUDAIRA, Takayuki, Yokohama-shi, Kanagawa 220-8680 (JP)
(74) Representative: Ter Meer Steinmeister & Partner
(86) International application number: PCT/JP2020/038355
(87) International publication number: WO 2021/075384

(57) **Abstract**

The disclosure includes: installing at least a vapor deposition material and substrates (S) inside a film-forming chamber (2a); setting a first region (A) including the substrates (S) inside the film-forming chamber (2a) to an atmosphere of 0.05 to 100 Pa by evacuation and/or supply of a gas that does not change a composition of the vapor deposition material; setting a second region (B) including the vapor deposition material inside the film-forming chamber (2a) to 0.05 Pa or less; and in this state, vaporizing the vapor deposition material in the second region (B) by a vacuum vapor deposition method to form films of the vaporized vapor deposition material on the vapor deposition objects in the first region (A).

## Description

### [Technical Field]

The present invention relates to a film-forming method and a film-forming apparatus and particularly to a film-forming method and a film-forming apparatus using a vacuum vapor deposition method.

### [Background Art]

CCDs and CMOSs used as imaging elements are liable to cause flare and ghosting because the light reflection from the surface is stronger than that from silver salt photographic films. In addition, in lenses having a small radius of curvature, the incident angle of light rays greatly differs depending on the position, so the low reflectance cannot be maintained on a portion at which the inclination of the lens surface is large. Furthermore, in flat displays such as LCDs, anti-glare treatment is employed to overcome the issue of glaring of external light due to light reflection on the display surface, but as the display density becomes higher, the transmitting light through the liquid crystal leads to diffused reflection on the anti-glare-treated surface, which may hinder the high resolution of images. In order to reduce such reflection on the substrate surface, film formation of a surface layer having a low refractive index may be necessary (Non-Patent Document 1).

### [Prior Art Document]

### [Non-Patent Document]

[Non-Patent Document 1] New Technologies for Reduction of Light Reflection (KIKUTA Hisao, Journal of the Optical Society of Japan "KOGAKU (Optics)," Vol. 40, No. 1, January 2011)

### [Summary of Invention]

### [Problems to be solved by Invention]

It has been known to form a surface layer on a glass having a refractive index of 1.5 by using a low-refractive-index material such as magnesium fluoride having a refractive index of 1.38. However, even when such a material having a refractive index of 1.38 is used, reflection of 1.4% remains. At present, there are no thin film materials having such low refractive indices as 1.1 to 1.2.

A problem to be solved by the present invention is to provide a film-forming method and a film-forming apparatus that are able to form a film having a low refractive index.

### [Means for solving problems]

An aspect of the present invention solves the above problem by providing a film-forming method comprising: installing at least a vapor deposition material and a vapor deposition object inside a film-forming chamber; setting an ambient pressure in a first region inside the film-forming chamber to 0.05 to 100 Pa by evacuation and/or supply of a gas that does not change a composition of the vapor deposition material, the first region including the vapor deposition object; setting an ambient pressure in a second region inside the film-forming chamber to 0.05 Pa or less (where the pressure in the first region ≠ the pressure in the second region, so when the ambient pressure in the first region is 0.05 Pa, the ambient pressure in the second region is less than 0.05 Pa, here and hereinafter), the second region including the vapor deposition material; and in this state, vaporizing the vapor deposition material in the second region by a vacuum vapor deposition method to form a film of the vaporized vapor deposition material on the vapor deposition object in the first region.

Another aspect of the present invention solves the above problem by providing a film-forming apparatus comprising: a film-forming chamber in which at least a vapor deposition material and a vapor deposition object are provided; a pressure setting device that sets an ambient pressure in a first region inside the film-forming chamber to 0.05 to 100 Pa and an ambient pressure in a second region inside the film-forming chamber to 0.05 Pa or less by evacuation and/or supply of a gas that does not change a composition of the vapor deposition material, the first region including the vapor deposition object, the second region including the vapor deposition material; and a control device that vaporizes the vapor deposition material in the second region in which the ambient pressure is set to 0.05 Pa or less and forms a film of the vaporized vapor deposition material on the vapor deposition object in the first region in which the ambient pressure is set to 0.05 to 100 Pa.

### [Effect of Invention]

According to the present invention, the second region including the vapor deposition material in the film-forming chamber is set to an ambient pressure of 0.05 Pa or less, and vacuum vapor deposition is therefore possible, while the first region including the vapor deposition object in the film-forming chamber is set to an ambient pressure of 0.05 to 100 Pa, and a film having a low refractive index can therefore be formed.

### [Brief Description of Drawings]

FIG. 1 is a schematic longitudinal cross-sectional view illustrating a first embodiment of a vacuum vapor deposition apparatus according to the present invention.
FIG. 2 is an arrow view taken along the line II-II of FIG. 1.
FIG. 3 is a graph illustrating ambient pressures in a first region A and a second region B illustrated in FIG. 1 and setting pressures of a first evacuation device and a second evacuation device (the vertical axis represents the logarithm of the pressure).
FIG. 4 is a schematic longitudinal cross-sectional view illustrating a second embodiment of a vacuum vapor deposition apparatus according to the present invention.
FIG. 5 is a schematic longitudinal cross-sectional view illustrating a third embodiment of a vacuum vapor deposition apparatus according to the present invention.
FIG. 6 is a schematic longitudinal cross-sectional view illustrating a fourth embodiment of a vacuum vapor deposition apparatus according to the present invention.
FIG. 7 is a schematic longitudinal cross-sectional view illustrating a fifth embodiment of a vacuum vapor deposition apparatus according to the present invention.
FIG. 8 is a schematic longitudinal cross-sectional view illustrating a sixth embodiment of a vacuum vapor deposition apparatus according to the present invention.
FIG. 9 is a schematic longitudinal cross-sectional view illustrating a seventh embodiment of a vacuum vapor deposition apparatus according to the present invention.
FIG. 10 is a schematic longitudinal cross-sectional view illustrating an eighth embodiment of a vacuum vapor deposition apparatus according to the present invention.
FIG. 11 is a schematic longitudinal cross-sectional view illustrating a ninth embodiment of a vacuum vapor deposition apparatus according to the present invention.

### [Mode(s) for Carrying out the Invention]

### «First Embodiment»

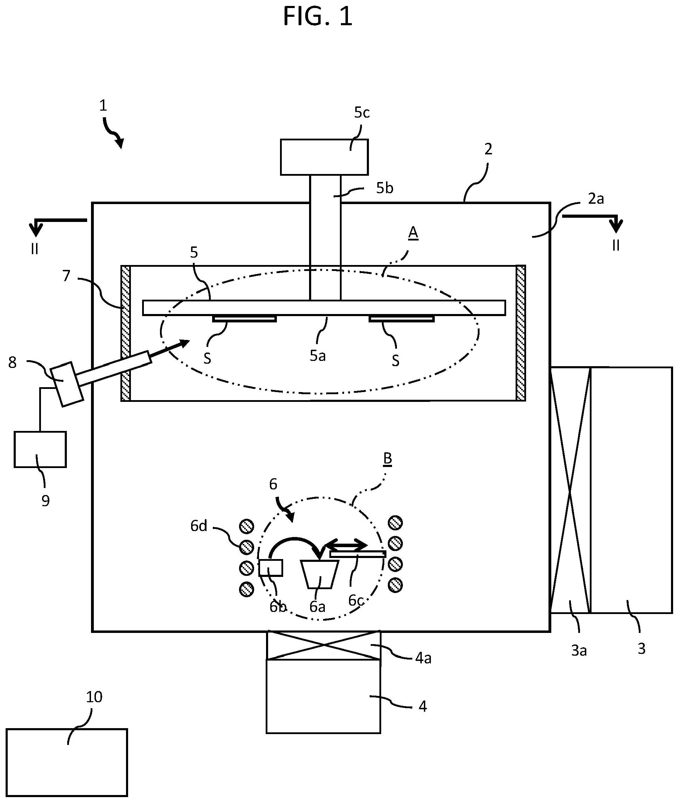

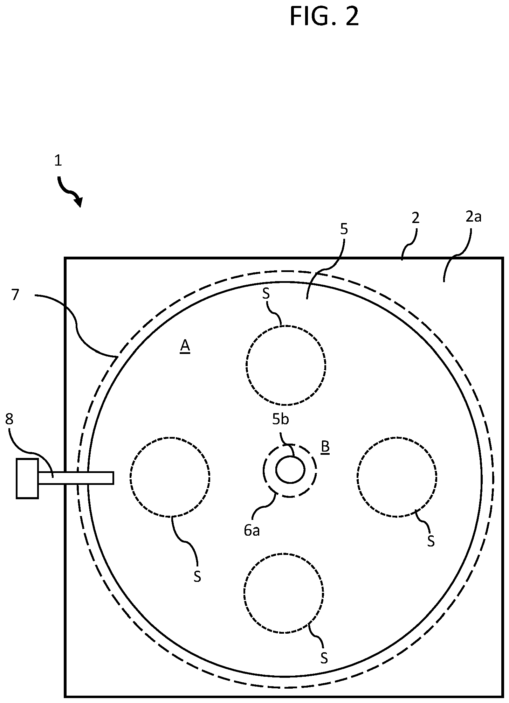

Hereinafter, embodiments of the present invention will be described with reference to the drawings. FIG. 1 is a schematic longitudinal cross-sectional view illustrating a vacuum vapor deposition apparatus 1 that represents a first embodiment of the film-forming apparatus according to the present invention, and FIG. 2 is an arrow view taken along the line II-II of FIG. 1. The vacuum vapor deposition apparatus 1 is also an apparatus that carries out the film-forming method according to the present invention.

The vacuum vapor deposition apparatus 1 of the present embodiment includes: a housing 2 constituting a film-forming chamber 2a that is substantially a closed space; a first evacuation device 3 for depressurizing the entire inside of the film-forming chamber 2a; a second evacuation device 4 that locally depressurizes a second region B inside the film-forming chamber 2a; a substrate holder 5 that holds substrates S that are vapor deposition objects; a vapor deposition mechanism 6; a shielding member 7 that impedes a part of a pressure reducing action to a first region A by the first evacuation device 3 and/or the second evacuation device 4, the first region A including the substrates S held by the substrate holder 5; a nozzle 8 and a gas supply source 9 that introduce a predetermined gas into the first region A; and a control device 10 that vaporizes a vapor deposition material while controlling the ambient pressure inside the film-forming chamber 2a and executes control to form films of the vaporized vapor deposition material on the substrates S.

The vacuum vapor deposition apparatus 1 of the present embodiment has the housing 2 which is formed in a box shape having an upper surface (ceiling surface), a lower surface (bottom surface), and a plurality of side surfaces or in a tubular shape having an upper surface (ceiling surface), a lower surface (bottom surface), and a curved side surface, and the inside of the housing 2 constitutes the film-forming chamber 2a as a substantially closed space. In the posture of the vacuum vapor deposition apparatus 1 illustrated in FIG. 1, the surface on the upper side of the housing 2 will be referred to as an upper surface, the surface on the lower side will be referred to as a lower surface, and the lateral surface or surfaces will be referred to as a side surface or side surfaces, as appropriate, but this is merely a convenient definition for describing the relative positional relationships between the housing 2 and the first evacuation device 3, the substrate holder 5, and the vapor deposition mechanism 6 which are provided in the housing 2, rather than absolutely defining the posture of the vacuum vapor deposition device 1 which is actually installed.

For example, in the vacuum vapor deposition apparatus 1 of the embodiment illustrated in FIG. 1, the substrate holder 5 and the vapor deposition mechanism 6 are arranged in the up-down direction (vertical direction), but the film-forming method and film-forming apparatus of the present invention are not limited to this arrangement, and the substrate holder 5 and the vapor deposition mechanism 6 may be arranged in the right-left direction, the horizontal direction, or a diagonal direction. Moreover, in the vacuum vapor deposition apparatus 1 of the embodiment illustrated in FIG. 1, the substrate holder 5 and the vapor deposition mechanism 6 are arranged in the up-down direction (vertical direction); therefore, the first evacuation device 3 is disposed on the side surface of the housing 2 while the second evacuation device 4 is disposed on the lower surface of the housing 2 due to the layout, but the film-forming method and film-forming apparatus of the present invention are not limited to this arrangement, and the first evacuation device 3 and the second evacuation device 4 can be arranged at appropriate positions with respect to the housing 2.

As illustrated in FIG. 1, the first evacuation device 3 is provided at approximately the center of the side surface of the housing 2 via a gate valve 3a. The gate valve 3a is an airtight valve that opens and closes the first evacuation device 3 and the film-forming chamber 2a, and when the film-forming chamber 2a is depressurized, the gate valve 3a is opened. On the other hand, the gate valve 3a is closed when the substrates S are put into the film-forming chamber 2a through an opening portion (not illustrated) or when the substrates S after being formed with films are taken out from the film-forming chamber 2a. Examples of the first evacuation device 3 include a turbo molecular pump (TMP) and a constant pressure pump (CP), and the first evacuation device 3 preferably has a rated capacity capable of depressurizing the inside of the film-forming chamber 2a to 0.01 Pa or less.

As illustrated in FIG. 1, the second evacuation device 4 is provided on the lower surface of the housing 2 and directly below the vapor deposition mechanism 6 via a gate valve 4a. The gate valve 4a is an airtight valve that opens and closes the second evacuation device 4 and the film-forming chamber 2a, and when the inside of the film-forming chamber 2a is depressurized, the gate valve 4a is opened. On the other hand, the gate valve 4a is closed when the substrates S are put into the film-forming chamber 2a through an opening portion (not illustrated) or when the substrates S after being formed with films are taken out from the film-forming chamber 2a. Examples of the second evacuation device 4 include a turbo molecular pump (TMP) and a constant pressure pump (CP), and the second evacuation device 4 preferably has a rated capacity capable of depressurizing the second region B including the vapor deposition mechanism 6 inside the film-forming chamber 2a to 0.01 Pa or less.

The substrate holder 5 in a plate-like shape is suspended by a rotating shaft 5b inside the film-forming chamber 2a, and the rotating shaft 5b is supported on the upper surface of the housing 2 in a rotatable manner. The substrate holder 5 is configured to be rotatable around the rotation shaft 5b which is rotated by a drive unit 5c. The substrates S which are vapor deposition objects of the vapor deposition material are held on a substrate holding surface 5a of the substrate holder 5. The number of substrates S held on the substrate holder 5 is not limited and may be one or two or more. The drive unit 5c may be omitted and the substrate holder 5 may not be rotatable. In the first embodiment illustrated in FIG. 1, a plurality of substrates S can be held on the substrate holding surface 5a of the substrate holder 5, and the substrate holder 5 is provided so that the plurality of substrates S is located directly above the vapor deposition mechanism 6.

The vapor deposition mechanism 6 is provided in the vicinity of the lower surface inside the film-forming chamber 2a. The vapor deposition mechanism 6 of the present embodiment is composed of an electron beam vapor deposition source and includes a crucible 6a filled with a vapor deposition material and an electron gun 6b that irradiates the vapor deposition material filling the crucible 6a with an electron beam. In addition, a shutter 6c is provided above the crucible 6a in a movable manner to open and close the upper opening of the crucible 6a. When the film-forming process is performed on the substrates S held on the substrate holder 5, the electron gun 6b is operated to heat and vaporize the vapor deposition material filling the crucible 6a, and the shutter 6c is opened to allow the vaporized vapor deposition material to attach to the substrates S. Reference numeral 6d illustrated in FIG. 1 represents the cooling tube coil of a Meissner trap, which efficiently removes the moisture released from the substrates S when the inside of the film-forming chamber 2a is evacuated. The vapor deposition material used in the vacuum vapor deposition apparatus 1 of the present embodiment is not particularly limited, and SiO₂, MgF₂, Al₂O₃, ZrO₂, Ta₂O₅, TiO₂, Nb₂O₅, HfO₂, or the like can be used.

In the vacuum vapor deposition apparatus 1 of the present embodiment, the shielding member 7 is fixed at a position surrounding the substrates S held by the substrate holder 5 including the substrate holder 5. The shielding member 7 of the present embodiment is formed in a tubular shape with opened upper and lower surfaces and controls a function of impeding a part of the gas evacuation from the film-forming chamber 2a by the first evacuation device 3 and/or the second evacuation device. That is, as illustrated in FIG. 1, provided that the region including the substrates S surrounded by the shielding member 7 is referred to as the first region A, when the gas inside the film-forming chamber 2a is evacuated by the first evacuation device 3 and/or the second evacuation device 4, the evacuation of the gas from the first region A is partially impeded thereby to reduce the pressure reducing effect on the first region A. The cross section of the shielding member 7 may be any of a circular, elliptical, or polygonal shape and may be set in accordance with the shape of the substrate holder 5.

The vacuum vapor deposition apparatus 1 of the present embodiment includes the nozzle 8 and the gas supply source 9 which introduce a predetermined inert gas or an active gas that does not change the composition of the vapor deposition material into the first region A including the substrates S held on the substrate holder 5. As illustrated in FIG. 1, the nozzle 8 may be fixed so as to penetrate, for example, the shielding member 7. The gas supply source 9 is a supply source for supplying an atmospheric gas inside the film-forming chamber 2a, for example, argon gas or other inert gas, a gas that does not change the composition of the vapor deposition material, or the like. The nozzle 8 and the gas supply source 9 are only aimed at increasing the ambient pressure in the first region A with respect to the surrounding pressure and are not to supply a reactive gas to form a reacted film. Therefore, even an active gas such as oxygen gas when the vapor deposition material is SiO₂,which does not change the composition of the vapor deposition material SiO₂,may be introduced into the first region A. This is because the oxygen gas when the vapor deposition material is SiO₂ may react with the formed SiO₂ film to some extent, but even when the oxygen gas reacts, it only generates SiO₂ and does not change the composition of the vapor deposition material SiO₂ which constitutes the film. FIG. 1 illustrates one nozzle 8 and one gas supply source 9, but two or more nozzles 8 may be connected to one or more gas supply sources 9 so as to blow a predetermined gas toward the first region A. Thus, the inside of the film-forming chamber 2a is an inert gas atmosphere or an active gas atmosphere that does not change the composition of the vapor deposition material.

The control device 10 controls ON/OFF of the first evacuation device 3, opening/closing of the gate valve 3a, ON/OFF of the second evacuation device 4, opening/closing of the gate valve 4a, rotation speed control including ON/OFF of the drive unit 5c for the substrate holder 5, operation control of the vapor deposition mechanism 6 including opening/closing of the shutter 6c, gas flow rate control including ON/OFF of the nozzle 8, etc. The film-forming control by a vacuum vapor deposition method is executed in a state in which the inside of the film-forming chamber 2a is controlled to a predetermined ambient pressure.

The action will then be described.

In the vacuum vapor deposition apparatus 1 of the present embodiment and the vacuum vapor deposition method using the vacuum vapor deposition apparatus 1, after the substrates S are mounted on the substrate holding surface 5a of the substrate holder 5 and the housing 2 is closed in an airtight manner, the control device 10 opens the gate valve 3a to operate the first evacuation device 3 and sets the setting value of the first evacuation device 3 to, for example, 0.01 Pa to depressurize the entire inside of the film-forming chamber 2a. Around this time, the gate valve 4a is opened to operate the second evacuation device 4, and the setting value of the second evacuation device 4 is set to, for example, 0.01 Pa to locally depressurize the second region B including the vapor deposition mechanism 6. At this time point, the drive unit 5c may be driven to start rotating the substrate holder 5 at a predetermined rotation speed.

With the passage of time, the inside of the film-forming chamber 2a is depressurized from the ordinary pressure, but in the first region A including the substrates S held by the substrate holder 5, the shielding member 7 impedes a part of the entire gas evacuation by the first evacuation device 3 and/or the second evacuation device 4, and at the same time the inert gas or the active gas which does not change the composition of the vapor deposition material is introduced through the nozzle 8 into the first region A including the substrates S held by the substrate holder 5; therefore, the ambient pressure in the first region A including the substrates S held by the substrate holder 5 is higher than that in the general region inside the film-forming chamber 2a. On the other hand, the ambient pressure in the second region B including the vapor deposition mechanism 6 which the depressurization suppressing effect by the shielding member 7 does not cover is lower than that in the general region inside the film-forming chamber 2a because the local gas evacuation is performed by the second evacuation device 4.

Preferably, when the ambient pressure in the second region B becomes 0.05 Pa or less and the ambient pressure in the first region A becomes 0.05 to 100 Pa due to the actions of the first evacuation device 3, the second evacuation device 4, the shielding member 7, the nozzle 8, and the gas supply source 9, the electron gun 6b of the vapor deposition mechanism 6 is operated to heat and vaporize the vapor deposition material filling the crucible 6a, and the shutter 6c is opened to allow the vaporized vapor deposition material to attach to the substrates S. Although not illustrated, a pressure sensor for detecting the ambient pressure is provided in each of the first region A and the second region B, and the control device 10 reads out the output signal of the pressure sensor thereby to execute the opening/closing control for the shutter 6c of the vapor deposition mechanism 6.

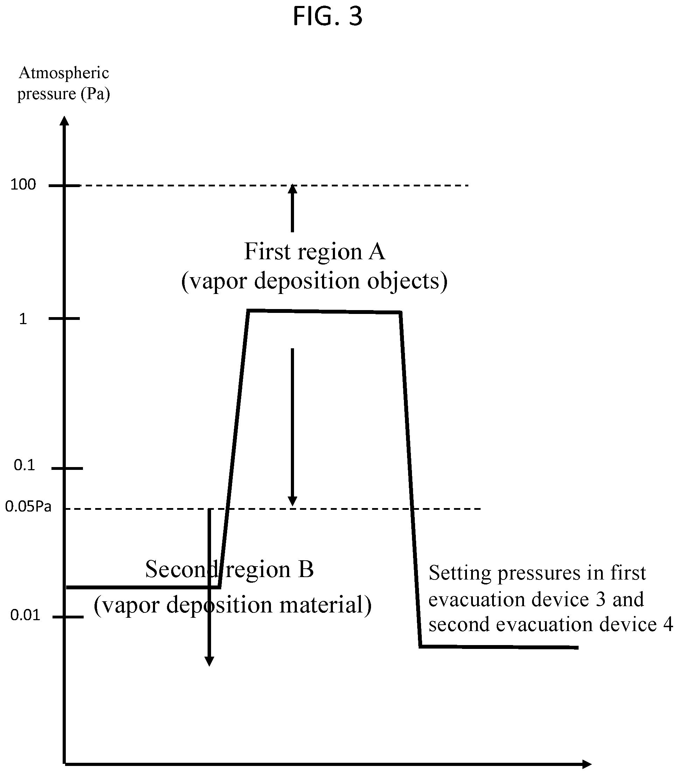

FIG. 3 is a graph illustrating the ambient pressures in the first region A and the second region B and the setting pressures of the first evacuation device 3 and the second evacuation device 4, and the vertical axis represents the logarithm of the pressure. The reason why the second region B including the vapor deposition mechanism 6 is set to 0.05 Pa or less as illustrated in the figure is that the vapor deposition material does not vaporize if the ambient pressure is higher than that pressure. On the other hand, the reason why the first region A including the substrates S is set to 0.05 Pa or more is that films having a low refractive index cannot be obtained if the ambient pressure is lower than that pressure, and the reason why the first region A including the substrates S is set to 100 Pa or less is that the vapor deposition material does not reach the substrates S and films cannot be formed if the ambient pressure is higher than that pressure. In the present embodiment, it suffices that the second region B including the vapor deposition mechanism 6 is set to 0.05 Pa or less and the first region A including the substrates S is set to 0.05 to 100 Pa, and therefore the setting pressures of the first evacuation device 3 and the second evacuation device 4 and the amount of gas supplied from the nozzle 8 and the gas supply source 9 are not particularly limited.

As described above, according to the vacuum vapor deposition apparatus 1 of the present embodiment and the film-forming method using the vacuum vapor deposition apparatus 1, the ambient pressure in the second region B including the vapor deposition mechanism 6 is set to a pressure that allows vapor deposition (preferably a pressure in the range close to the upper limit) while the ambient pressure in the first region A including the substrates S is set to a relatively higher pressure, and films having a low refractive index can therefore be obtained by the vacuum vapor deposition method.

The above substrates S correspond to the vapor deposition object of the present invention;
the above first evacuation device 3, the above second evacuation device 4, the above shielding member 7, the above nozzle 8, and the above gas supply source 9 correspond to the pressure setting device of the present invention;
the above first evacuation device 3 and the above second evacuation device 4 correspond to the pressure reducing device of the present invention;
the above shielding member 7, the above nozzle 8, and the above gas supply source 9 correspond to the pressure increasing device of the present invention;
the above nozzle 8 and the above gas supply source 9 correspond to the gas supply device of the present invention;
the above first evacuation device 3, the above shielding member 7, the above nozzle 8, and the above gas supply source 9 correspond to the first pressure reducing device of the present invention; and
the above second evacuation device 4 corresponds to the second pressure reducing device of the present invention.

### «Second Embodiment»

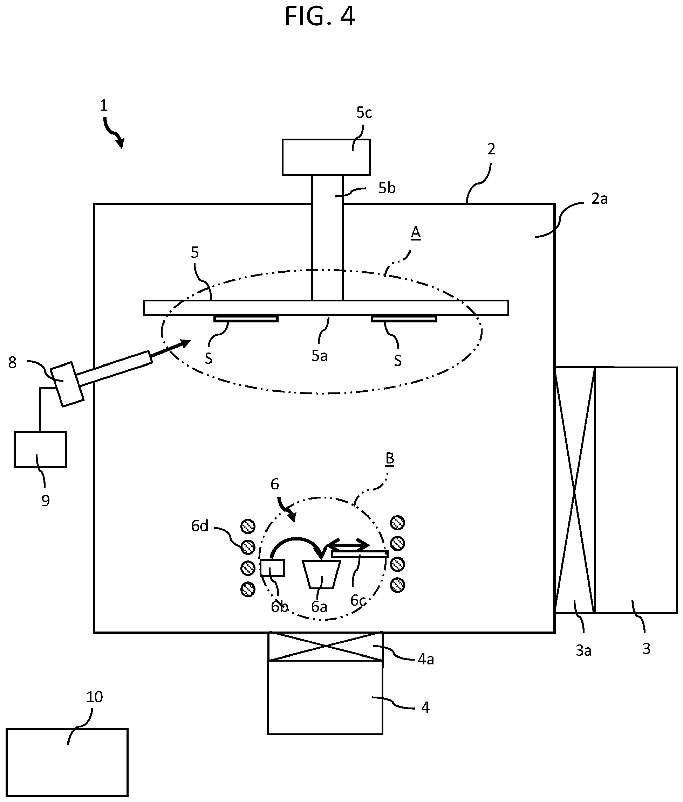

FIG. 4 is a schematic longitudinal cross-sectional view illustrating a second embodiment of the vacuum vapor deposition apparatus 1 according to the present invention. The vacuum vapor deposition apparatus 1 of the present embodiment is different from the vacuum vapor deposition apparatus 1 of the first embodiment illustrated in FIGS. 1 and 2 in that the shielding member 7 is not provided. In the film-forming method and film-forming apparatus of the present invention, it may suffice that the ambient pressure in the first region A can be set to 0.05 to 100 Pa, and the shielding member 7 can therefore be omitted depending, for example, on the configurations and capacities of the first evacuation device 3, the second evacuation device, the nozzle 8, and the gas supply source 9. Other configurations are the same as those of the first embodiment, so the description of the first embodiment is borrowed herein. As in the first embodiment, the nozzle 8 and the gas supply source 9 supply argon gas or other inert gas or a gas that does not change the composition of the vapor deposition material, and the inside of the film-forming chamber 2a is an inert gas atmosphere or an active gas atmosphere that does not change the composition of the vapor deposition material.

### «Third Embodiment»

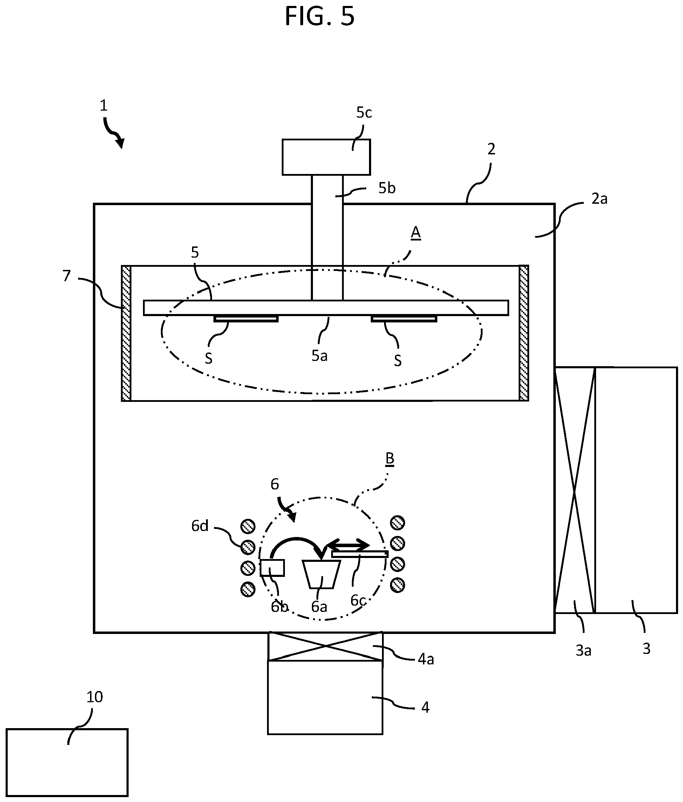

FIG. 5 is a schematic longitudinal cross-sectional view illustrating a third embodiment of the vacuum vapor deposition apparatus 1 according to the present invention. The vacuum vapor deposition apparatus 1 of the present embodiment is different from the vacuum vapor deposition apparatus 1 of the first embodiment illustrated in FIGS. 1 and 2 in that the nozzle 8 and the gas supply source 9 are not provided.

In the film-forming method and film-forming apparatus of the present invention, it may suffice that the ambient pressure in the first region A can be set to 0.05 to 100 Pa, and the nozzle 8 and the gas supply source 9 can therefore be omitted depending, for example, on the configurations and capacities of the first evacuation device 3, the second evacuation device, and the shielding member 7. However, although the nozzle 8 and the gas supply source 9 are not used as the means for generating a pressure gradient, a gas supply system (not illustrated) supplies argon gas or other inert gas or a gas that does not change the composition of the vapor deposition material to the inside of the film-forming chamber 2a, and the inside of the film-forming chamber 2a is thereby an inert gas atmosphere or an active gas atmosphere that does not change the composition of the vapor deposition material. Other configurations are the same as those of the first embodiment, so the description of the first embodiment is borrowed herein.

### «Fourth Embodiment»

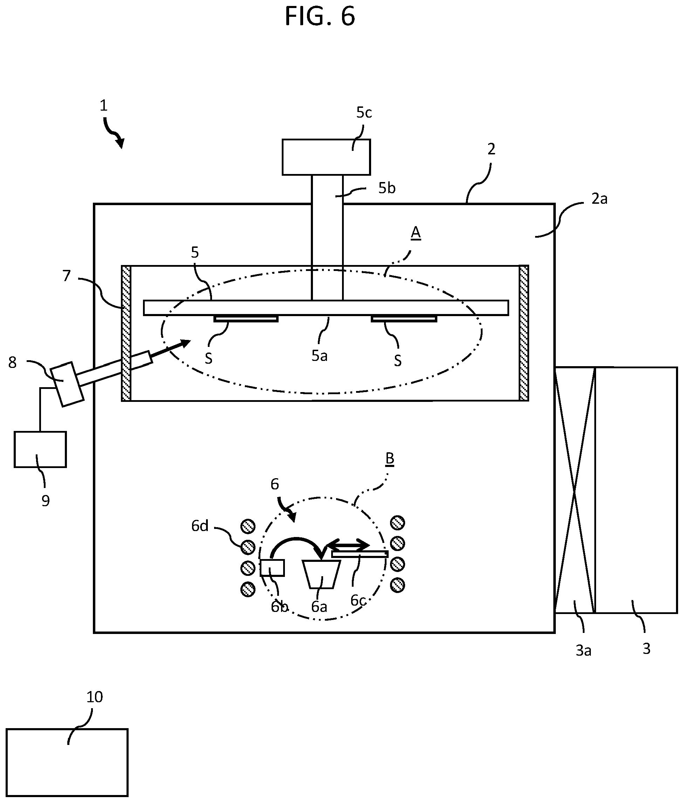

FIG. 6 is a schematic longitudinal cross-sectional view illustrating a fourth embodiment of the vacuum vapor deposition apparatus 1 according to the present invention. The vacuum vapor deposition apparatus 1 of the present embodiment is different from the vacuum vapor deposition apparatus 1 of the first embodiment illustrated in FIGS. 1 and 2 in that the second evacuation device 4 is not provided. As in the first embodiment, the nozzle 8 and the gas supply source 9 supply argon gas or other inert gas or a gas that does not change the composition of the vapor deposition material, and the inside of the film-forming chamber 2a is an inert gas atmosphere or an active gas atmosphere that does not change the composition of the vapor deposition material.

In the film-forming method and film-forming apparatus of the present invention, it may suffice that the ambient pressure in the second region B can be set to 0.05 Pa or less, and the second evacuation device 4 can therefore be omitted depending, for example, on the configurations and capacities of the first evacuation device 3, the shielding member 7, the nozzle 8, and the gas supply source 9. Other configurations are the same as those of the first embodiment, so the description of the first embodiment is borrowed herein.

### «Fifth Embodiment»

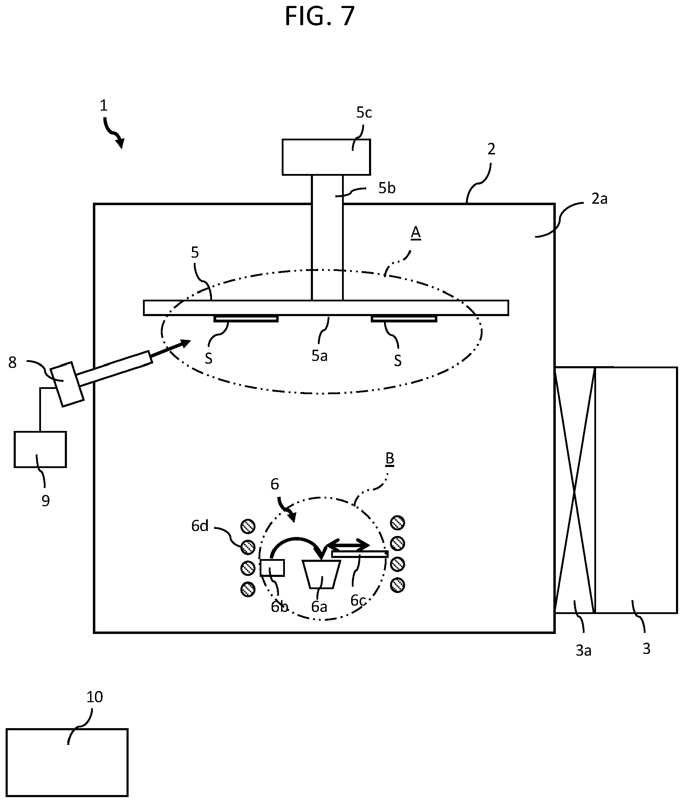

FIG. 7 is a schematic longitudinal cross-sectional view illustrating a fifth embodiment of the vacuum vapor deposition apparatus 1 according to the present invention. The vacuum vapor deposition apparatus 1 of the present embodiment is different from the vacuum vapor deposition apparatus 1 of the first embodiment illustrated in FIGS. 1 and 2 in that the shielding member 7 is not provided and the second evacuation device 4 is not provided. In the film-forming method and film-forming apparatus of the present invention, it may suffice that the ambient pressure in the first region A can be set to 0.05 to 100 Pa, and the shielding member 7 can therefore be omitted depending, for example, on the configurations and capacities of the first evacuation device 3, the nozzle 8, and the gas supply source 9. Moreover, in the film-forming method and film-forming apparatus of the present invention, it may suffice that the ambient pressure in the second region B can be set to 0.05 Pa or less, and the second evacuation device 4 can therefore be omitted depending, for example, on the configurations and capacities of the first evacuation device 3, the nozzle 8, and the gas supply source 9. Other configurations are the same as those of the first embodiment, so the description of the first embodiment is borrowed herein. As in the first embodiment, the nozzle 8 and the gas supply source 9 supply argon gas or other inert gas or a gas that does not change the composition of the vapor deposition material, and the inside of the film-forming chamber 2a is an inert gas atmosphere or an active gas atmosphere that does not change the composition of the vapor deposition material.

### «Sixth Embodiment»

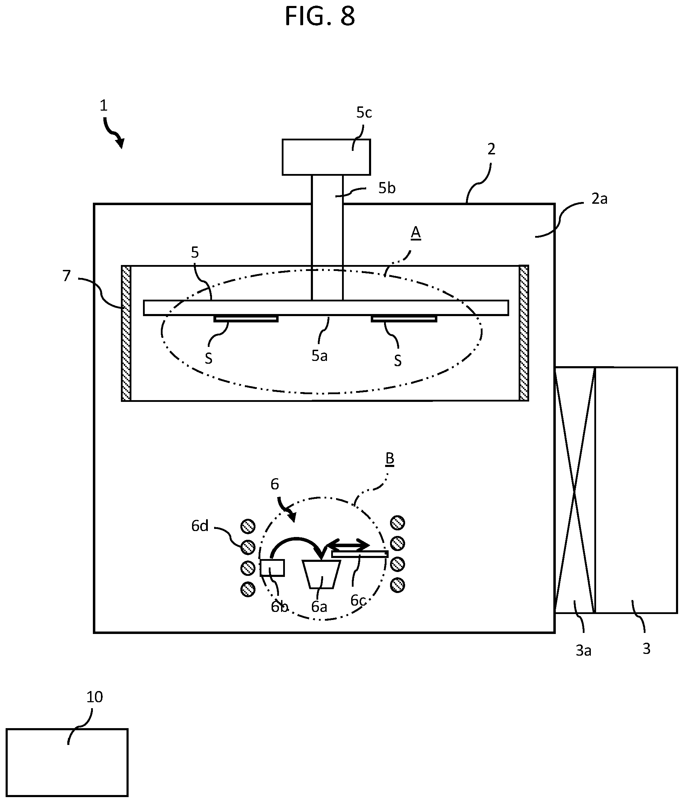

FIG. 8 is a schematic longitudinal cross-sectional view illustrating a sixth embodiment of the vacuum vapor deposition apparatus 1 according to the present invention. The vacuum vapor deposition apparatus 1 of the present embodiment is different from the vacuum vapor deposition apparatus 1 of the first embodiment illustrated in FIGS. 1 and 2 in that the second evacuation device 4 is not provided and the nozzle 8 and the gas supply source 9 are not provided.

In the film-forming method and film-forming apparatus of the present invention, it may suffice that the ambient pressure in the first region A can be set to 0.05 to 100 Pa, and the nozzle 8 and the gas supply source 9 can therefore be omitted depending, for example, on the configurations and capacities of the first evacuation device 3 and the shielding member 7. However, although the nozzle 8 and the gas supply source 9 are not used as the means for generating a pressure gradient, a gas supply system (not illustrated) supplies argon gas or other inert gas or a gas that does not change the composition of the vapor deposition material to the inside of the film-forming chamber 2a, and the inside of the film-forming chamber 2a is thereby an inert gas atmosphere or an active gas atmosphere that does not change the composition of the vapor deposition material. Moreover, in the film-forming method and film-forming apparatus of the present invention, it may suffice that the ambient pressure in the second region B can be set to 0.05 Pa or less, and the second evacuation device 4 can therefore be omitted depending, for example, on the configurations and capacities of the first evacuation device 3 and the shielding member 7. Other configurations are the same as those of the first embodiment, so the description of the first embodiment is borrowed herein.

### «Seventh Embodiment»

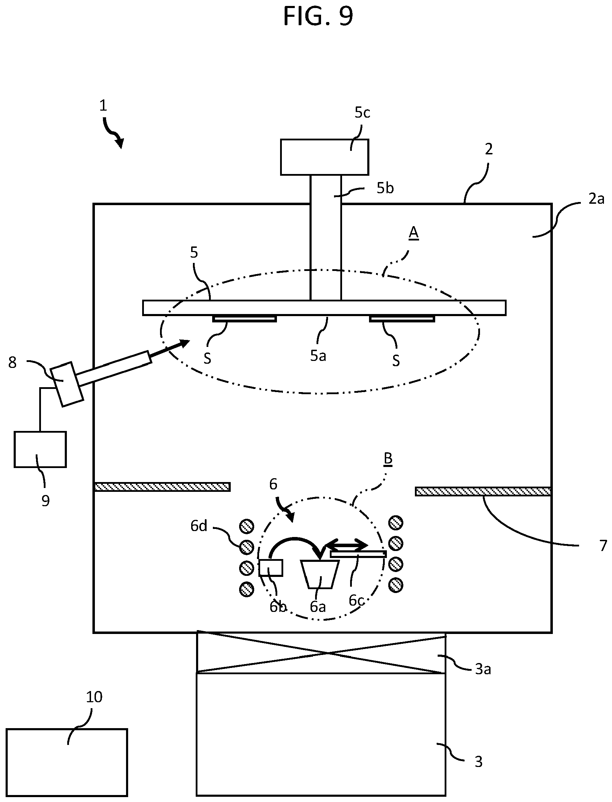

FIG. 9 is a schematic longitudinal cross-sectional view illustrating a seventh embodiment of the vacuum vapor deposition apparatus 1 according to the present invention. The vacuum vapor deposition apparatus 1 of the present embodiment is different from the vacuum vapor deposition apparatus 1 of the first embodiment illustrated in FIGS. 1 and 2 in the configuration of a shielding member 7 and the installation positions of a first evacuation device 3 and a gate valve 3a and also different in that the second evacuation device 4 is not provided.

In the vacuum vapor deposition apparatus 1 of the present embodiment, as illustrated in FIG. 9, the first evacuation device 3 is provided on the lower surface of the housing 2, that is, in the vicinity of the vapor deposition mechanism 6, via the gate valve 3a. The gate valve 3a is an airtight valve that opens and closes the first evacuation device 3 and the film-forming chamber 2a.

In the vacuum vapor deposition apparatus 1 of the present embodiment, the shielding member 7 is fixed inside the film-forming chamber 2a and between the first region A including the substrates S held on the substrate holder 5 and the second region B including the vapor deposition mechanism 6. The shielding member 7 of the present embodiment is composed of a plate member whose center is open in a circular shape, an elliptical shape, a rectangular shape, or the like, and controls a function of impeding a part of the gas evacuation from the film-forming chamber 2a by the first evacuation device 3. That is, as illustrated in FIG. 9, provided that the region including the substrates S held on the substrate holder 5 is referred to as the first region A, when the gas inside the film-forming chamber 2a is evacuated by the first evacuation device 3, the evacuation of the gas from the first region A is partially impeded thereby to reduce the pressure reducing effect on the first region A.

In the film-forming method and film-forming apparatus of the present invention, it may suffice that the ambient pressure in the second region B can be set to 0.05 Pa or less, and the second evacuation device 4 can therefore be omitted depending, for example, on the configurations and capacities of the first evacuation device 3, the shielding member 7, the nozzle 8, and the gas supply source 9. Other configurations are the same as those of the first embodiment, so the description of the first embodiment is borrowed herein. As in the first embodiment, the nozzle 8 and the gas supply source 9 supply argon gas or other inert gas or a gas that does not change the composition of the vapor deposition material, and the inside of the film-forming chamber 2a is an inert gas atmosphere or an active gas atmosphere that does not change the composition of the vapor deposition material.

### «Eighth Embodiment»

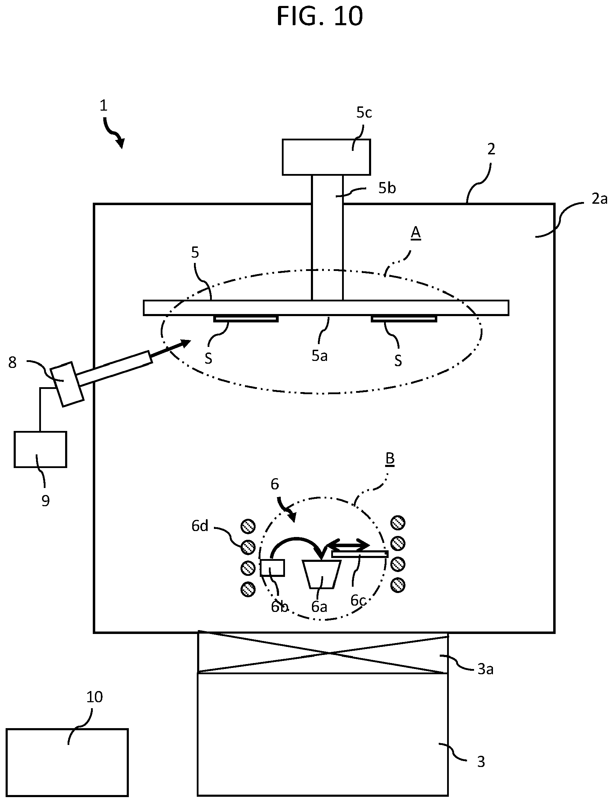

FIG. 10 is a schematic longitudinal cross-sectional view illustrating an eighth embodiment of the vacuum vapor deposition apparatus 1 according to the present invention. The vacuum vapor deposition apparatus 1 of the present embodiment is different from the vacuum vapor deposition apparatus 1 of the first embodiment illustrated in FIGS. 1 and 2 in the installation positions of a first evacuation device 3 and a gate valve 3a and also different in that the shielding member 7 is not provided and the second evacuation device 4 is not provided. The installation positions of the first evacuation device 3 and the gate valve 3a are the same as those of the seventh embodiment of FIG. 9, so the description is borrowed herein.

In the film-forming method and film-forming apparatus of the present invention, it may suffice that the ambient pressure in the first region A can be set to 0.05 to 100 Pa, and the shielding member 7 can therefore be omitted depending, for example, on the configurations and capacities of the first evacuation device 3, the nozzle 8, and the gas supply source 9. Moreover, in the film-forming method and film-forming apparatus of the present invention, it may suffice that the ambient pressure in the second region B can be set to 0.05 Pa or less, and the second evacuation device 4 can therefore be omitted depending, for example, on the configurations and capacities of the first evacuation device 3, the nozzle 8, and the gas supply source 9. Other configurations are the same as those of the first embodiment, so the description of the first embodiment is borrowed herein. As in the first embodiment, the nozzle 8 and the gas supply source 9 supply argon gas or other inert gas or a gas that does not change the composition of the vapor deposition material, and the inside of the film-forming chamber 2a is an inert gas atmosphere or an active gas atmosphere that does not change the composition of the vapor deposition material.

### «Ninth Embodiment»

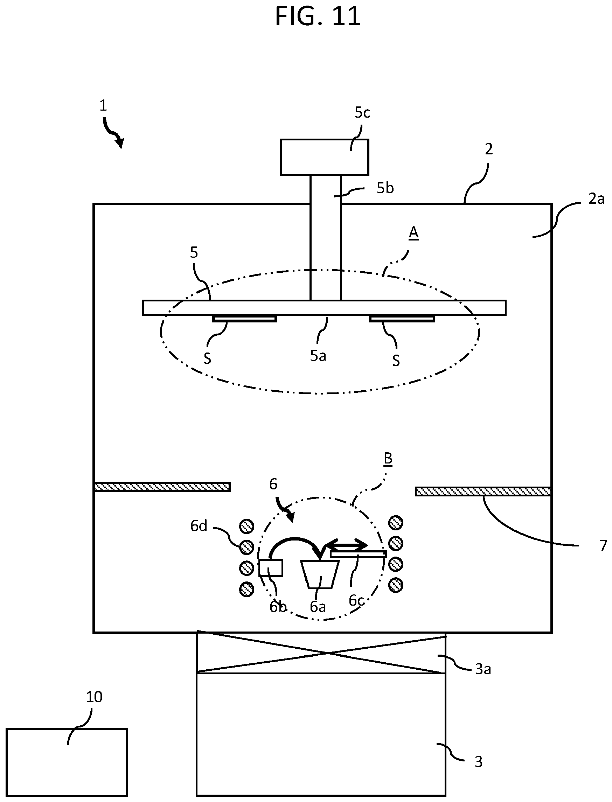

FIG. 11 is a schematic longitudinal cross-sectional view illustrating a ninth embodiment of the vacuum vapor deposition apparatus 1 according to the present invention. The vacuum vapor deposition apparatus 1 of the present embodiment is different from the vacuum vapor deposition apparatus 1 of the first embodiment illustrated in FIGS. 1 and 2 in the configuration of a shielding member 7 and the installation positions of a first evacuation device 3 and a gate valve 3a and also different in that the nozzle 8 and the gas supply source 9 are not provided and the second evacuation device 4 is not provided. The configuration of the shielding member 7 and the installation positions of the first evacuation device 3 and the gate valve 3a are the same as those of the seventh embodiment of FIG. 9, so the description is borrowed herein.

In the film-forming method and film-forming apparatus of the present invention, it may suffice that the ambient pressure in the first region A can be set to 0.05 to 100 Pa, and the nozzle 8 and the gas supply source 9 can therefore be omitted depending, for example, on the configurations and capacities of the first evacuation device 3 and the shielding member 7. However, although the nozzle 8 and the gas supply source 9 are not used as the means for generating a pressure gradient, a gas supply system (not illustrated) supplies argon gas or other inert gas or a gas that does not change the composition of the vapor deposition material to the inside of the film-forming chamber 2a, and the inside of the film-forming chamber 2a is thereby an inert gas atmosphere or an active gas atmosphere that does not change the composition of the vapor deposition material. Moreover, in the film-forming method and film-forming apparatus of the present invention, it may suffice that the ambient pressure in the second region B can be set to 0.05 Pa or less, and the second evacuation device 4 can therefore be omitted depending, for example, on the configurations and capacities of the first evacuation device 3 and the shielding member 7. Other configurations are the same as those of the first embodiment, so the description of the first embodiment is borrowed herein.

In the above-described first to ninth embodiments, the vacuum vapor deposition apparatus 1 has been described as adopting a so-called batch-type production scheme in which after the film formation on the substrates S mounted on the substrate holder 5 is completed, the film-forming chamber 2a is returned to the atmospheric air pressure atmosphere and the substrates S after film formation are released while the substrates S before film formation are mounted, but the vacuum vapor deposition apparatus 1 may adopt a so-called continuous production scheme in which a load lock chamber is connected to the film-forming chamber 2a via a partition valve and the substrate holder 5 on which the substrates S are mounted is carried in/out through the load lock chamber.

Moreover, in the above-described first to ninth embodiments, semiconductor wafers, glass substrates, or the like are exemplified as the film formation objects to be formed with vapor deposition films and are mounted on the substrate holder 5, but a film formation object wound in a roll shape, such as a long film, may be used. In the case of a film formation object wound in a roll shape, a feed-side roller that supports the roll before film formation and feeds out the film and a wind-up roller that winds up the film after film formation may be provided as substitute for the substrate holder 5.

### «Optical Thin Film»

The film obtained by the film-forming method of each of the above-described embodiments is not particularly limited, but is a film having a refractive index of 1.38 or less and a pencil hardness of 2B or more and can be used as an optical thin film. The film such as an optical thin film obtained by the film-forming method of each of the above-described embodiments is not particularly limited, but may be composed of a single film such as an optical thin film or may also be applied to a multilayer film such as an optical thin film. When the film such as an optical thin film obtained by the film-forming method of the present embodiments is applied to a multilayer film, the film of the present embodiments may be applied to any of the lowermost layer, an intermediate layer, and the outermost surface. Furthermore, an organic film may be formed on the surface of the film such as an optical thin film obtained by the film-forming method of the present embodiments.

### [Examples]

### «Example 1»

The vacuum vapor deposition apparatus 1 of FIGS. 1 and 2 was used to form a SiO₂ film with a target film thickness of 600 nm on one surface of a glass substrate S (N-BK7 available from SCHOTT AG, plate thickness 1.0 mm, ϕ 30 mm, refractive index n: 1.5168). The film-forming conditions at that time were as follows: the vertical distance between the crucible 6a of the vapor deposition mechanism 6 and the substrate S illustrated in FIG. 1 was set to 35 to 70 cm, the target ambient pressure in the first region A was set to 1 Pa, and the target ambient pressure in the second region B was set to 0.001 Pa. SiO₂ was used as the vapor deposition material, and the current amount of the electron gun 6b was set to 170 mA. The substrate S was heated to 200°C.

For the obtained SiO₂ film, the spectral transmittance and the spectral reflectance were measured using a spectrophotometer (U-4100 available from Hitachi High-Tech Corporation), and the refractive index of the film after film formation was calculated from the transmittance and the reflectance. For the same film, the pencil hardness test (in accordance with JIS K5600, Testing methods for paints, 4.4 Scratch hardness (Pencil hardness method)) was performed. The refractive index represents the refractive index at a wavelength of 550 nm. The results are listed in Table 1.

### «Comparative Example 1»

In the vacuum vapor deposition apparatus 1 used in Example 1, a film was formed under the same conditions as those in Example 1 except that the supply of the inert gas from the nozzle 8 was stopped and the vacuum degree of the entire inside of the film-forming chamber 2a was set to 0.001 Pa to perform the film formation by vacuum vapor deposition. The pencil hardness and the refractive index at a wavelength of 550 nm of the obtained SiO₂ film are listed in Table 1.

**[Table 1]**

| | Pencil hardness | Refractive index |
|---|---|---|
| Example 1 | 2B | 1.351 |
| Comparative Example 1 | 9H | 1.457 |

### «Consideration»

As listed in the results of Comparative Example 1, when the SiO₂ film is formed on the surface of the glass substrate by a conventionally known vacuum vapor deposition method, the formed film has a refractive index that is approximately equal to the refractive index of 1.46 of the film-forming material SiO₂ itself. On the other hand, as listed in the results of Example 1, when the vacuum vapor deposition method is performed with the ambient pressure in the first region A set to 0.05 to 100 Pa and the pressure in the second region B set to 0.05 Pa or less, the formed film has a refractive index of 1.31 to 1.41 that is lower than the refractive index of 1.46 of the film-forming material SiO₂ itself. Moreover, it is generally said that a low refractive index film has low mechanical strength, but in Example 1, a film having a pencil hardness test result of 2B has been formed.

### [Description of Reference Numerals]

- 1: Vacuum vapor deposition apparatus
- 2: Housing
2a Film-forming chamber

- 3: First evacuation device
3a Gate valve

- 4: Second evacuation device
4a Gate valve

- 5: Substrate holder
5a Substrate holding surface
5b Rotation shaft
5c Drive unit

- 6: Vapor deposition mechanism
6a Crucible
6b Electron gun
6c Shutter
6d Meissner trap

- 7: Shielding member
- 8: Nozzle
- 9: Gas supply source
- 10: Control device
- A: First region
- B: Second region
- S: Substrate

## Claims

1. A film-forming method comprising:
installing at least a vapor deposition material and a vapor deposition object inside a film-forming chamber;
setting an ambient pressure in a first region inside the film-forming chamber to 0.05 to 100 Pa by evacuation and/or supply of a gas that does not change a composition of the vapor deposition material, the first region including the vapor deposition object;
setting an ambient pressure in a second region inside the film-forming chamber to 0.05 Pa or less, the second region including the vapor deposition material; and
in this state, vaporizing the vapor deposition material in the second region by a vacuum vapor deposition method to form a film of the vaporized vapor deposition material on the vapor deposition object in the first region.

2. The film-forming method according to claim 1, wherein the film has a refractive index of 1.38 or less and a pencil hardness of 2B or more.

3. The film-forming method according to claim 1 or 2, wherein the vapor deposition material is SiO₂.

4. A film-forming apparatus comprising:
a film-forming chamber in which at least a vapor deposition material and a vapor deposition object are provided;
a pressure setting device that sets an ambient pressure in a first region inside the film-forming chamber to 0.05 to 100 Pa and an ambient pressure in a second region inside the film-forming chamber to 0.05 Pa or less by evacuation and/or supply of a gas that does not change a composition of the vapor deposition material, the first region including the vapor deposition object, the second region including the vapor deposition material; and
a control device that vaporizes the vapor deposition material in the second region in which the ambient pressure is set to 0.05 Pa or less and forms a film of the vaporized vapor deposition material on the vapor deposition object in the first region in which the ambient pressure is set to 0.05 to 100 Pa.

5. The film-forming apparatus according to claim 4, wherein the pressure setting device comprises:
a pressure reducing device that depressurizes entire inside of the film-forming chamber to an ambient pressure that allows vapor deposition; and
a pressure increasing device that locally increases the ambient pressure in the first region including the vapor deposition object inside the film-forming chamber with respect to the ambient pressure inside the film-forming chamber.

6. The film-forming apparatus according to claim 5, wherein the pressure increasing device includes a gas supply device that supplies an inert gas to the first region inside the film-forming chamber.

7. The film-forming apparatus according to claim 5 or 6, wherein the pressure increasing device includes a shielding member that impedes a part of a pressure reducing action to the first region by the pressure reducing device.

8. The film-forming apparatus according to claim 4, wherein the pressure setting device comprises:
a first pressure reducing device that depressurizes entire inside of the film-forming chamber including the first region to a pressure higher than an ambient pressure that allows vapor deposition; and
a second pressure reducing device that locally depressurizes the second region including the vapor deposition material inside the film-forming chamber to a pressure that allows vapor deposition.

9. The film-forming apparatus according to claim 8, wherein the first pressure reducing device includes a gas supply device that supplies an inert gas to the first region inside the film-forming chamber.

10. The film-forming apparatus according to claim 8 or 9, wherein the first pressure reducing device includes a shielding member that impedes a part of a pressure reducing action to the first region by the first pressure reducing device and/or the second pressure reducing device.
